# EUROPEAN PATENT SPECIFICATION

(11) **EP 3 375 840 B1**
(45) Date of publication and mention of the grant of the patent: **29.07.2020**
(21) Application number: 18164112.7
(22) Date of filing: 24.04.2015
(51) Int. Cl.: C09K 11/78

(54) **CRYSTALLINE MATERIAL, PROCESS FOR PRODUCING IT AND USE THEREOF**
KRISTALLINES MATERIAL, VERFAHREN ZUR HERSTELLUNG DAVON UND VERWENDUNG DAVON
MATÉRIAU CRISTALLIN, SON PROCÉDÉ DE PRÉPARATION ET SON UTILISATION

(30) Priority: 25.04.2014 DE 102014105846
(43) Date of publication of application: 19.09.2018
(62) Divisional of application: 15720659.0
(73) Proprietor: Polysecure GmbH, 79108 Freiburg (DE)
(72) Inventor: Baque, Thomas, 67714 Waldfischbach-Burgalben (DE); Moesslein, Jochen, 79100 Freiburg (DE)
(74) Representative: Scholz, Volker

(56) References cited:
- DE-A1-102010 034 256
- US-A- 4 225 653
- US-A1- 2010 163 747
- US-A1- 2011 024 648
- PANG T ET AL: "Up-conversion luminescence of trivalent-rare-earth ion-doped LnTaO4 (Ln=Y, Gd, La)", MATERIALS LETTERS, NORTH HOLLAND PUBLISHING COMPANY. AMSTERDAM, NL, vol. 62, no. 16, 15 June 2008 (2008-06-15) , pages 2500-2502, XP022611942, ISSN: 0167-577X, DOI: 10.1016/J.MATLET.2007.12.031 [retrieved on 2008-01-11]

## Description

The present invention relates to a crystalline material, a process for producing it and uses thereof.

Anti-Stokes crystals based on yttrium oxisulphide and gadolinium oxisulphide, doped with rare earths have been known for many years. These crystals are typically produced by means of solid-phase synthesis. When excited with IR radiation of a particular wavelength, they exhibit distinct luminescence. These crystals are used *inter alia* as marking agents for detecting forgeries.

The sulphur and its compounds contained in the crystals can easily be released as sulphur dioxide or hydrogen sulphide by acids and/or heating. Moist and warm ambient air is in some cases already sufficient to cause this. Because of the odour and physiological harmfulness of the sulphur compounds, it is impossible to use these substances in many applications. Examples here are everyday articles, food packaging, pharmaceutical and medical products.

Processes are described in WO 1998039392 A1 which make it possible to reduce the amount of sulphur. It was not, however, possible to dispense with it altogether.

Furthermore, because of the production process, a uniform particle size is not achieved. In order to achieve the maximum conversion of the IR radiation into visible light, however, it is desirable to have a uniform crystal with as few interfaces and defects as possible. The performance of the crystals produced in this way is therefore only moderate. The crystal size can only be adjusted within narrow limits, and in particular small crystals, such as those used in the manufacture of printing inks, inks, films and monofilaments, can only be achieved by grinding the crystals. Because of the procedure used, the crystals are broken down in the process, as a result of which their performance, especially the quantum yield, drops.

A further disadvantage of the process is that ultra-pure metal oxides have to be used in the synthesis. As a rule, oxides with a purity of 99.99999 % (5-nine grade) are used. These are correspondingly expensive and in their availability they have to compete with the growing demand in the semiconductor and illumination industry.

DE 10 2010 034 256 A1 discloses a luminescent substance exhibiting a host lattice doped with a luminescent activator and the use thereof in diagnostic or therapeutic methods, in tissue labelling or in graphical angiographic methods.

US 2010/163,747 A1 discloses a printed value document having at least one luminescent substance. With respect to the luminescent substance, reference is made to a material having the general formula XZO₄, wherein X and Z represent different metals.

US 4,225,653 A discloses an X-ray intensifying screen based on rare earth tantalate. The rare earth tantalate has a formula YNbₓTa₁₋ₓO_{4.}

US 2011/024648 A1 discloses luminescent compounds chosen from compounds of formula Y₂BaZnO₅:Er³⁺, La₂BaZnO₅:Er³⁺, Gd₂BaZnO₅:Er³⁺, Gd₂BaZnO₅:Yb³⁺/Er³⁺, and Gd₂BaZnO₅:Yb³⁺/Tm³⁺.

Pang et al., Material Letters, 2008, 62, 2500 discloses up-conversion luminescence of trivalent-rare-earth ion-doped LnTaO₄ materials with Ln being Y, Gd or La.

It is a problem of the present invention to provide a crystalline material which overcomes the disadvantages of the state of the art, in particular is free of sulphur, can be manufactured in a simple manner and can be used as a marking agent, preferably exploiting an anti-Stokes effect of the crystalline material.

This problem is solved in accordance with the subject-matter of the independent claims. Preferred embodiments result from the sub-claims.

This problem is in particular solved by a crystalline material comprising a basic crystal based on at least one host element (We), which basic crystal is doped with at least one element of the rare earths (Do), the crystalline material having the formula:

We1₍ₐ₎We2_{(b)}Ta_{(c)}Do1_{(d)}Do2₍ₑ₎Hal_{(w)}O₍ₓ₎Te_{(y)}Se_{(z)},

where We1 and We2 are independently and differently selected from elements from the group consisting of niobium, aluminium, barium, gadolinium, lanthanum, yttrium, cerium, and titanium; Do₁ and Do₂ are independently and differently selected from elements of the group of rare earths; Hal is fluoride, chloride, bromide or iodide; the indices (a)-(z) each being 0 to 3 independently of one another, though at least one of (a) and (b) is greater than 0, at least one of (d) and (e) is greater than 0, and at least one of (w), (x), (y) and (z) is greater than 0; wherein the sum of (a)+(b)+(c)=1 -2, preferably 1 or 2, and the sum of (w)+(x)+(y)+(z)= 2 or 3, with the proviso that (c) is > 0 if

We₁ = Ce, Do₁ = Er and (b) = (e) = (w) = (y) = (z) = 0,

wherein (x) is >0, characterised in that the rare-earth element is selected from erbium, ytterbium, thulium and holmium, preferably a combination of two rare-earth oxides, preferably erbium oxide and ytterbium oxide. It may preferably be contemplated that (c) is > 0.

It is preferable that We1 and/or We2 is/are present in a +3 or +4, preferably +3, oxidation state.

It may particularly preferably be contemplated that (x) is > 0. It is also preferable that (w) = (y) = (z) = 0. Tellurium and selenium, if present, are likewise preferably present as tellurite or selenite. Preferred host elements are gadolinium and lanthanum, preferably in oxidic form. It is likewise preferable that (y) = (z) = 0 and/or (b) = 0 and/or (e) = 0.

In a particularly preferred embodiment, the crystalline material of the invention does not comprise lanthanum fluoride (LaF₃) and/or yttrium fluoride (YF₃). The crystalline material of the invention does not comprise any europium, especially no yttrium oxide doped with europium yttrium fluoride (YF₃). The crystalline material does not contain any dysprosium (Dy).

It may also be contemplated that the basic crystal is doped with 0.5 - 10 per cent by weight rare-earth oxide, based on the total weight of the crystalline material

The rare-earth element is selected from erbium, ytterbium, thulium and holmium, preferably a combination of two rare-earth oxides, preferably erbium oxide and ytterbium oxide.

A further problem is solved by a process (sol-gel process) for producing a crystalline material of the invention, said process comprising the steps of: a) providing aqueous solutions of salts or oxides of the elements to be used, b) mixing the aqueous solutions from step a) in a desired ratio, c) adding an oxidising agent and a glycol and/or polyglycol to the mixture from step b), d) heating a mixture produced in step c) to a temperature of 50-150° C, preferably 60-120° C, to form a gel, e) heating the gel to a temperature of at least 175° C, preferably in a furnace, to convert the gel into a powder, f) annealing the powder obtained in step e) at a temperature of at least 500° C, preferably 500-2,000° C.

It may be contemplated in this connection that ethylene glycol, propylene glycol, their polycompounds and/or glycerol is/are used as the glycol or polyglycol.

It may also be contemplated that the oxidising agent is nitric acid or hydrogen peroxide.

It may further be preferably contemplated that the heating in step d) is performed for a period of 1-10 hours, preferably 3-7 hours, and/or the heating in step e) is performed for a period of 0.1-2 hours and/or the annealing in step f) is performed for a period of 1-24 hours.

It is preferably contemplated that the annealing in step f) is performed on the basis of a temperature-time gradient.

A further problem is solved by a process (hydro process) for producing a crystalline material of the invention, which process comprises the steps of: i) preparing aqueous solutions of the elements to be used in their nitrate form, ii) optionally accompanied by cooling and stirring, adding ammonium hydroxide, until no precipitate is deposited any longer, iii) rinsing the precipitate with water, iv) drying the precipitate obtained in step iii) and annealing at 600-1,700° C, preferably 1,000-1,300° C, for preferably 0.1-12 hours, even more preferably 0.25-1 hour.

If in this process the starting element compounds are not present in the form of their nitrate salts, but rather in oxidic form or as carbonates, those compounds can be reacted to their nitrates with nitric acid while being heated, preferably in a stirred tank. Then after the solution has cooled down, preferably accompanied by cooling and intensive stirring, ammonium hydroxide may be added until no precipitate is deposited any longer. The further procedure is then analogous to the steps described above.

The invention also relates to the use of the crystalline material as a marking agent for marking materials, especially technical products and components, everyday articles, food packaging, pharmaceuticals, medical products, luxury goods and security documents. Corresponding materials may, for example, comprise metals, plastics, glasses, etc.

It has surprisingly been found in accordance with the invention that the anti-Stokes crystals prepared are free of sulphur and, in their manufacture, solve the problems known from the state of the art, such as raw materials supplies. In addition, almost perfect crystals can be produced in a purposive manner in a wide range of sizes. The anti-Stokes crystals of the invention permit their use as marking agents for detecting forgeries; they may, for example, be used with no problems in many everyday articles, food packaging, pharmaceuticals and medical products.

If the basic crystals also contain tantalum, the luminance of the anti-Stokes crystal is improved still further.

The crystalline material of the invention is preferably an anti-Stokes crystal.

The advantage of the sol-gel process is that very fine crystals can be produced, whereas the hydro process, i.e. the reaction with nitric acid and ammonium hydroxide, has the advantage that it can be performed very quickly.

Further advantages and features of the crystalline material of the invention and its production process will become clear from the following general and detailed description, illustrated with reference to examples.

The crystalline materials of the invention are produced in a first alternative in a modified sol-gel process. For this purpose, it is preferable for aqueous solutions of the nitrates of the elements to be mixed with glycols or polyglycols and an oxidising agent and heated. After a few hours, the sol produced in this way turns into a gel. Because of their good solubility and easy synthesis, nitrates are preferable, but other salts of the elements may be used if needed.

In principle, all glycols or polyglycols can be used. Ethylene and propylene glycol and their polycompounds are preferred, however. Glycerol is likewise preferred.

As the oxidising agent, nitric acid is preferred, but other oxidising agents, such as hydrogen peroxide, are also suitable.

At temperatures of at least 175° C, with a highly exothermal reaction, the gel is converted into the oxide crystals of the starting substances. These are formed as a very fine, voluminous powder. That is then annealed at temperatures higher than 500° C. Depending on the time and temperature, crystals of different sizes are formed, which exhibit different decay times of the luminescence. The general rule is that the size of the crystal increases as the temperature and time increase.

### General course of the production of the crystalline materials according to the sol-gel process

There are alternative ways of preparing the elements to be used for the production of the aqueous solutions, see 1.a and 1.b below.

### 1. Production of the solutions of the elements

a. Nitrates of the elements were dissolved as a 1M solution in 1:4 diluted nitric acid. The purity of the compounds is preferably at least 99.99 %.
b. Oxides of the elements are dissolved, with heating, in nitric acid which is concentrated or diluted with water by up to 20 %. In the process, the corresponding nitrates form. If necessary, the solution can be purified of unwanted substances or elements by physical (filtration, centrifugation, etc.) or chemical (e.g. precipitation) processes.

### 2. Production of the sol

a. The nitric solutions of the element nitrates are mixed in the corresponding ratio.
b. After that, 3-20 % by weight glycol or polyglycol, based on the total weight of the solutions, is added. It is preferable to use ethylene glycol or low-molecular-weight polyethylene glycol. Alternatively, propylene glycol may also be used.

### 3. Formation of the gel

a. The mixture is heated to a temperature of 60-90° C accompanied by stirring and is kept at that temperature for several hours. In the process, the viscosity of the solution increases and a gel forms.
b. After the desired viscosity has been reached, the gel is filled into dishes.

### 4. Oxidation

a. The dishes filled with gel are placed in a furnace at a temperature of approx. 200° C. In the process, the remaining water first evaporates.
b. After that, a powerful exothermal reaction begins. This leads to a distinct increase in the furnace temperature.
c. Once the reaction has subsided, the fine powder formed is filled into crucibles of aluminium oxide.

### 5. Annealing process

a. The crucibles are annealed in an annealing furnace at 500 - 2,000° C. The annealing time may be up to 24 hours. The invention also relates to the preferred use of a temperature-time gradient.
b. As an alternative to batch annealing in the muffle furnace, it is also possible to perform a continuous annealing process in a continuous furnace or rotary kiln.
c. After cooling, the powder is removed from the crucibles and if necessary crushed and sieved. For this purpose, standard processes used in chemical production are employed, with which the skilled person is familiar.

### General course of the production of the crystalline materials according to the hydro process

There are alternative ways of preparing the elements to be used for the production of the aqueous solutions, see 1.a and 1.b below.

### 1. Production of the solutions of the elements

a. Nitrates of the elements were dissolved as a 1M solution in 1:4 diluted nitric acid. The purity of the compounds is preferably at least 99.9 %.
b. Oxides of the elements are dissolved, with heating, in nitric acid which is concentrated or diluted with water by up to 20 %. In the process, the corresponding nitrates form. If necessary, the solution can be purified of unwanted substances or elements by physical (filtration, centrifugation, etc.) or chemical (e.g. precipitation) processes.

### 2. Formation of the hydroxides

a. The nitric solutions of the element nitrates are mixed in the corresponding ratio.
b. Accompanied by intensive stirring, preferably with a rotor-stator mixer (known as "Turax") and cooling, concentrated aqueous ammonium hydroxide solution is added until the elements are completely precipitated.
c. The hydroxides are rinsed several times with demineralised water in order to remove surplus ammonium hydroxide.

### 3. Separating and drying the hydroxide

a. The precipitate is separated from the water by filtration or preferably centrifugation.
b. Then the residue is dried to a residual moisture of 5 % , preferably less than 1 %. Processes for this purpose are known; preferred processes are spray-drying and microwave drying.

### 4. Annealing process

a. The crucibles are annealed in an annealing furnace at 500 - 2,000° C. The annealing time may be up to 24 hours. The invention also relates to the preferred use of a temperature-time gradient.
b. As an alternative to batch annealing in the muffle furnace, it is also possible to perform a continuous annealing process in a continuous furnace or rotary kiln.
c. After cooling, the powder is removed from the crucibles and if necessary crushed and sieved. For this purpose, standard processes used in chemical production are employed, with which the skilled person is familiar.

### Example 1:

### Crystal based on cerium(IV)-tantalum oxide

20.3g (0.06 mole) Ce(NO₃)₃ are prepared as a 1M solution in a 600 ml glass beaker. Then 30ml concentrated nitric acid, 3 ml 1M Ta(NO₃)₃ and 5ml 1M Er(NO₃)₃ solution are added. Accompanied by stirring and heating to 60° C, 120 ml, ethylene glycol are added. The solution is kept at 60° C for 6 hours. In that time, the colour of the solution, which is originally pink, turns a deep red and the viscosity of the solution increases considerably. The gel is transferred to a shallow porcelain dish and left to stand overnight to dry.

The dish is placed in a muffle furnace at a temperature of approx. 200° C. After approx. 15 minutes, a sharp rise in temperature in the muffle furnace can be observed. After a further 15 minutes, the gel has changed into a fine white powder. That is transferred to an aluminium oxide crucible and subsequently annealed for 4 hours at 800° C.

The anti-Stokes effect can be detected as a distinct red luminescence with an excitation source of 980 nm.

### Example 2 (comparative)

### Crystal based on calcium-scandium-tantalum oxide

20 ml of a 1M Ca(NO₃)₂ solution are placed in a glass beaker with 20 ml 1M Sc(NO₃)₃ solution and 0.6 ml each of 1M Yb(NO₃)₃ and Er(NO₃)₃. 2 ml Ta(NO₃)₃ 1M solution, 100 ml water and 10 ml concentrated nitric acid are then added and heated for 30 min to 80° C accompanied by stirring. Now, 40g polyethylene glycol 400 and 0.5 ml glycerol are added. The temperature is raised to 120° C. After 4 hours, the reaction was stopped and the gel formed was transferred to a porcelain dish.

The dish is placed in a muffle furnace at a temperature of 200° C. After approx. 15 minutes, a sharp rise in temperature in the muffle furnace can be observed. After a further 15 minutes, the gel has changed into a fine white powder. Even here, luminescent crystals can be observed when excited at 980 nm.

The powder is transferred to an aluminium oxide crucible and subsequently annealed for 4 hours at 800° C.

The anti-Stokes effect can be detected as a distinct green luminescence with an excitation source of 980 nm.

### Example 3

### Crystal based on gadolinium-tantalum oxide

28.8g Gd₂O₃, 1.6 g Yb₂O₃ and 0.2g Er₂O₃ are placed in a 600 ml Erlenmeyer flask. 60ml concentrated nitric acid and 5 ml Ta(NO₃)₃ 1M solution are added. The substances are dissolved accompanied by stirring and heating to 90° C.

After the solution has cooled, aqueous 25 % NH₄OH solution is added, accompanied by intensive stirring, until no further precipitation occurs. The precipitate is rinsed 3 times with the water and is then separated. After that, it is dried in a drying cabinet for 24 hours at 150° C.

The powder is transferred to an aluminium oxide crucible and subsequently annealed for 2 hours at 1,000° C.

The anti-Stokes effect can be detected as a distinct orange luminescence with an excitation source of 980 nm.

The crystalline materials produced in this way can be used as marking agents for marking materials in order to be able to distinguish genuine original products/materials from forgeries. The anti-Stokes effect, or the anti-Stokes fluorescence emitted, is used for this purpose. The use of anti-Stokes materials as marking agents is known in the art.

The features of the invention disclosed in the above description and in the claims can be essential to implementing the invention in its various embodiments both individually and in any combination.

## Claims

1. A crystalline material comprising a basic crystal based on at least one host element (We), which basic crystal is doped with at least one element of the rare earths (Do), the crystalline material having the formula:
We1₍ₐ₎We2_{(b)}Ta_{(c)}Do1_{(d)}Do2₍ₑ₎Hal_{(w)}O₍ₓ₎Te_{(y)}Se_{(z)},
where We1 and We2 are independently and differently selected from elements from the group consisting of niobium, aluminium, barium, gadolinium, lanthanum, yttrium, cerium, and titanium; Do₁ and Do₂ are independently and differently selected from elements of the group of rare earths; Hal is fluoride, chloride, bromide or iodide; the indices (a)-(z) each being 0 to 3 independently of one another, though at least one of (a) and (b) is greater than 0, at least one of (d) and (e) is greater than 0, and at least one of (w), (x), (y) and (z) is greater than 0; wherein the sum of (a)+(b)+(c)=1-2, preferably 1 or 2, and the sum of (w)+(x)+(y)+(z)= 2 or 3, with the proviso that (c) is > 0 if
We₁ = Ce, Do₁ = Er and (b) = (e) = (w) = (y) = (z) = 0,
wherein (x) is >0,
**characterised in that** the rare-earth element is selected from erbium, ytterbium, thulium and holmium, preferably a combination of two rare-earth oxides, preferably erbium oxide and ytterbium oxide.

2. The crystalline material as claimed in claim 1, **characterised in that** (c) > 0 ist.

3. The crystalline material as claimed in either of claims 1 or 2, **characterised in that** We₁ and/or We₂ is/are present in a +3 or +4, preferably +3, oxidation state.

4. The crystalline material as claimed in any of the preceding claims, **characterised in that** the basic crystal is doped with 0.5 - 10 per cent by weight rare-earth oxide, based on the total weight of the crystalline material.

5. A process for producing a crystalline material as claimed in any of claims 1 to 4, said process comprising the steps of:
a) providing aqueous solutions of salts or oxides of the elements to be used,
b) mixing the aqueous solutions from step a) in a desired ratio,
c) adding an oxidising agent and a glycol and/or polyglycol to the mixture from step b),
d) heating a mixture produced in step c) to a temperature of 50-150° C, preferably 60-120° C, to form a gel,
e) heating the gel to a temperature of at least 175° C, preferably in a furnace, to convert the gel into a powder,
f) annealing the powder obtained in step e) at a temperature of at least 500° C, preferably 500-2,000° C.

6. The process as claimed in claim 5, **characterised in that** ethylene glycol, propylene glycol, their polycompounds and/or glycerol is/are used as the glycol or polyglycol.

7. The process as claimed in either of claims 5 or 6, **characterised in that** the oxidising agent is nitric acid or hydrogen peroxide.

8. A process for producing a crystalline material as claimed in any of claims 1 to 4, said process comprising the steps of:
i) preparing aqueous solutions of the elements to be used in their nitrate form,
ii) optionally accompanied by cooling and stirring, adding ammonium hydroxide, until no precipitate is deposited any longer,
iii) rinsing the precipitate with water,
iv) drying the precipitate obtained in step iii) and annealing at 600-1,700° C, preferably 1,000-1,300° C, for preferably 0.1-12 hours, even more preferably 0.25-1 hour.

9. Use of a crystalline material as claimed in any of claims 1 to 4 as a marking agent for marking materials, especially technical products and components, everyday articles, food packaging, pharmaceuticals, medical products, luxury goods and security documents.

## Patentansprüche

1. Kristallines Material umfassend einen Grundkristall auf Basis zumindest eines Wirtselements (We), welcher Grundkristall mit zumindest einem Element der Seltenen Erden (Do) dotiert ist, wobei das kristalline Material die Formel aufweist:
We1₍ₐ₎We2_{(b)}Ta_{(c)}Do1_{(d)}Do2₍ₑ₎ Hal_{(w)}O₍ₓ₎Te_{(y)}Se_{(z)}
wobei We1 und We2 unabhängig und unterschiedlich ausgewählt sind aus Elementen aus der Gruppe bestehend aus Niob, Aluminium, Barium Gadolinium, Lanthan, Yttrium, Cer und Titan; Do1 und Do2 unabhängig und unterschiedlich ausgewählt sind aus Elementen der Gruppe der Seltenen Erden; Hal Fluorid, Chlorid, Bromid oder Iodid ist; wobei (a)-(z) jeweils unabhängig voneinander o bis 3 sind, jedoch zumindest eines von (a) und (b) größer o ist, zumindest eines von (d) und (e) größer o ist, und zumindest eines von (w), (x), (y) und (z) größer o ist; wobei die Summe aus (a)+(b)+(c)=1-2, vorzugsweise 1 oder 2, ist und die Summe aus (w)+(x)+(y)+(z)=2 oder 3 ist, mit der Maßgabe, dass (c) > o ist, wenn
We₁ = Ce ist, Do₁ = Er ist und (b) = (e) = (w) = (y) = (z) = 0 ist,
wobei (x) > o ist,
**dadurch gekennzeichnet, dass** das Element der Seltenen Erden ausgewählt ist aus Erbium, Ytterbium, Thulium und Holmium, bevorzugt eine Kombination von zwei Oxiden der Seltenen Erden ist, vorzugsweise Erbiumoxid und Ytterbiumoxid.

2. Kristallines Material nach Anspruch 1, **dadurch gekennzeichnet, dass** (c) > o ist.

3. Kristallines Material nach Anspruch 1 oder 2, **dadurch gekennzeichnet, dass** We1 und/oder We2 in einer Oxidationsstufe +3 oder +4, bevorzugt +3, vorliegt bzw. vorliegen.

4. Kristallines Material nach einem der vorangehenden Ansprüche, **dadurch gekennzeichnet, dass** der Grundkristall mit 0,5-10 Gewichtsprozent Oxid der Seltenen Erden dotiert ist, bezogen auf das Gesamtgewicht des kristallinen Materials.

5. Verfahren zum Herstellen eines kristallinen Materials nach einem der Ansprüche 1 bis 4, welches Verfahren die Schritte umfasst:
a) Bereitstellen wässriger Lösungen von Salzen oder Oxiden der einzusetzenden Elemente,
b) Mischen der wässrigen Lösungen aus Schritt a) in einem gewünschten Verhältnis,
c) Zugeben eines Oxidationsmittels und eines Glykols und/oder Polyglykols zur Mischung aus Schritt b),
d) Erwärmen eines in Schritt c) hergestellten Gemisches auf eine Temperatur von 50-150°C, bevorzugt 60-120°C, zur Ausbildung eines Gels,
e) Erwärmen des Gels auf eine Temperatur von mindestens 175°C, vorzugsweise in einem Ofen, zur Umwandlung des Gels in ein Pulver,
f) Glühen des in Schritt e) erhaltenen Pulvers bei einer Temperatur von mindestens 500°C, bevorzugt 500-2000°C.

6. Verfahren nach Anspruch 5, **dadurch gekennzeichnet, dass** als Glykol oder Polyglykol Ethylenglykol, Propylenglykol, deren Polyverbindungen und/oder Glycerin eingesetzt wird bzw. werden.

7. Verfahren nach Anspruch 5 oder 6, **dadurch gekennzeichnet, dass** das Oxidationsmittel Salpetersäure oder Wasserstoffperoxid ist.

8. Verfahren zum Herstellen eines kristallinen Materials nach einem der Ansprüche 1 bis 4, welches Verfahren die Schritte umfasst:
i) Bereitstellen wässriger Lösungen der einzusetzenden Elemente in ihrer Nitratform,
ii) Optional unter Kühlung und Rühren, Zugabe von Ammoniumhydroxid, bis kein Niederschlag mehr ausfällt,
iii) Waschen des Niederschlags mit Wasser,
iv) Trocknen des in Schritt iii) erhaltenen Niederschlags und Glühen bei 600-1700°C, vorzugsweise 1000-1300°C, für vorzugsweise 0,1-12 Stunden, noch bevorzugter 0,25-1 Stunde.

9. Verwendung eines kristallinen Materials nach einem der Ansprüche 1 bis 4 als Markierungsmittel zum Markieren von Materialien, insbesondere technischen Produkten und Bauteilen, Bedarfsgegenständen, Lebensmittelverpackungen, Arzneimitteln, Medizinprodukten, Luxusgütern und Wertdokumenten.

## Revendications

1. Matériau cristallin comprenant un cristal de base faisant appel à au moins un élément hôte (We), ledit cristal de base étant dopé avec au moins un élément des terres rares (Do), le matériau cristallin ayant la formule :
We1₍ₐ₎We2_{(b)}Ta_{(c)}Do_{1(d)}Do2₍ₑ₎Hal_{(w)}0₍ₓ₎Te_{(y)}Se_{(z)},
dans laquelle formule We1 et We2 sont sélectionnés indépendamment et différemment parmi les éléments du groupe constitué du niobium, de l'aluminium, du baryum, du gadolinium, du lanthane, de l'yttrium, du cérium et du titane ; Do₁ et Do₂ sont sélectionnés indépendamment et différemment parmi les éléments du groupe des terres rares ; Hal représente le fluorure, le chlorure, le bromure ou l'iodure ; les indices (a) à (z) valent chacun de 0 à 3 indépendamment l'un de l'autre, bien qu'au moins l'un des (a) et (b) soit supérieur à 0, qu'au moins l'un des (d) et (e) soit supérieur à 0, et qu'au moins l'un des (w), (x), (y) et (z) soit supérieur à 0 ; où la somme de (a) + (b) + (c) = 1 à 2, de préférence 1 ou 2, et la somme de (w) + (x) + (y) + (z) = 2 ou 3, à condition que (c) soit > 0 si
We₁ = Ce, Do₁ = Er and (b) = (e) = (w) = (y) = (z) = 0,
où (x) est supérieur à 0,
**caractérisé en ce que** l'élément des terres rares est sélectionné parmi l'erbium, l'ytterbium, le thulium et l'holmium, de préférence une combinaison de deux oxydes des terres rares, de préférence l'oxyde d'erbium et l'oxyde d'ytterbium,

2. Matériau cristallin selon la revendication 1, **caractérisé en ce que** (c) > 0 ist.

3. Matériau cristallin selon la revendication 1 ou 2, **caractérisé en ce que** We₁ et/ou We₂ est/sont présent(s) dans un état d'oxydation de +3 ou +4, de préférence de +3.

4. Matériau cristallin selon l'une des revendications précédentes, **caractérisé en ce que** le cristal de base est dopé avec 0,5 - 10 pour cent en poids d'oxyde des terres rares, par rapport au poids total du matériau cristallin.

5. Procédé de production d'un matériau cristallin tel que revendiqué dans l'une quelconque des revendications 1 à 4, ledit procédé comprenant les étapes consistant à :
a) fournir des solutions aqueuses de sels ou d'oxydes des éléments à utiliser.
b) mélanger les solutions aqueuses depuis l'étape a) dans un rapport souhaité,
c) ajouter un agent oxydant et un glycol et/ou un polyglycol au mélange issu de l'étape b),
d) chauffer un mélange produit à l'étape c) à une température de 50 à 150 °C, de préférence de 60 à 120 °C, pour former un gel,
e) chauffer le gel à une température d'au moins 175 °C, de préférence dans un four, pour transformer le gel en poudre,
f) recuire la poudre obtenue à l'étape e) à une température d'au moins 500 °C, de préférence de 500 à 2.000 °C.

6. Procédé selon la revendication 5, **caractérisé en ce que** l'éthylène glycol, le propylène glycol, leurs polycomposés et/ou le glycérol est/sont utilisé(s) comme glycol ou polyglycol.

7. Procédé selon l'une des revendications 5 ou 6, **caractérisé en ce que** l'agent oxydant est l'acide nitrique ou le peroxyde d'hydrogène.

8. Procédé de production d'un matériau cristallin selon l'une des revendications 1 à 4, ledit procédé comprenant les étapes consistant à :
i) préparer des solutions aqueuses des éléments à utiliser sous leur forme nitrate,
ii) éventuellement accompagnées d'un refroidissement et d'une agitation, en ajoutant de l'hydroxyde d'ammonium, jusqu'à ce qu'aucun précipité ne soit plus déposé,
iii) rincer le précipité avec de l'eau,
iv) sécher le précipité obtenu à l'étape iii) et le recuire à une température de 600 à 1.700 °C, de préférence à 1.000 à 1.300 °C, pendant de préférence 0,1 à 12 heures, et encore plus préférablement 0,25 à 1 heure.

9. Utilisation d'un matériau cristallin selon l'une des revendications 1 à 4 comme agent de marquage pour le marquage des matériaux, en particulier des produits et composants techniques, des articles de la vie courante, des emballages alimentaires, des produits pharmaceutiques, des produits médicaux, des produits de luxe et des documents de sécurité.
